# EUROPEAN PATENT APPLICATION

(11) **EP 4 064 346 A1**
(43) Date of publication of application: **28.09.2022**
(21) Application number: 21164927.2
(22) Date of filing: 25.03.2021
(51) Int. Cl.: H01L 25/07, H01L 23/538

(54) **POWER MODULE COMPRISING SWITCH ELEMENTS AND DIODES**

(71) Applicant: Hitachi Energy Switzerland AG, 5400 Baden (CH)
(72) Inventor: SCHROEDER, Arne, 3012 Bern (CH); ORTIZ, Gabriel Ignacio, 8005 Zürich (CH)
(74) Representative: Epping - Hermann - Fischer

(57) **Abstract**

A power module (1) comprises a first switch (2) comprising a first switch element (9) and an associated first diode (10), a second switch (3) comprising a second switch element (11) and an associated second diode (12), the first and second switches (2, 3) being electrically connected to form a half-bridge, wherein the switch elements (9, 11) and diodes (10, 12) are located next to each other, wherein the second switch element (11) and second diode (12) are located between the first switch element (9) and the first diode (10).

## Description

The present disclosure relates to a power module comprising first and second switches, each switch comprising at least one switch element and an associated diode. The switches are connected to form a half-bridge. A half-bridge is an electric circuit comprising two switches connected in series between a DC+ and DC- terminal, wherein an AC terminal is connected between the switches. The switch connected to the DC+ terminal is denoted as high side (HS) switch, the switch connected to the DC- terminal is denoted as low side (LS) switch.

Half-bridge power modules form the key building blocks in various power electronic devices, such as motor drives or power converters which can be used in electric vehicles (EV). Power modules need to be compact and designed to operate in harsh environments for a long period of time. The power modules may comprise silicon (Si), silicon carbide (SiC), gallium nitride (GaN) or other semiconductor elements. Three half-bridge power modules form a so-called six-pack power module, forming the three phases of an inverter. The electromagnetic design of the switches is crucial for exploiting the fast switching capabilities of the device.

Documents WO 2010/004802 A1 and WO 2013/171996 A1 disclose different power module layouts. Document EP 3 246 945 A1 discloses a power module with three DC terminals arranged with alternating polarity for reducing the contribution of the terminals to stray inductance of the power module. Embodiments of the disclosure relate to a power module with improved electromagnetic properties.

According to an embodiment, a power module comprises a first switch comprising a first switch element and an associated first diode and comprises a second switch comprising a second switch element and an associated second diode. Each of the switch elements is electrically connected in parallel to its associated diode. The first and second switches are electrically connected to form a half-bridge. The switch elements and diodes are located next to each other, wherein the second switch element and second diode may be located between the first switch element and the first diode.

The power module may be a Si, or a wide-bandgap module such as a SiC or GaN module, for example. The switch elements may be insulated gate bipolar transistors (IGBT), as an example. The switch elements may be alternatively MOSFET or MISFET transistors, for example. The associated diodes may be free-wheeling diodes (FWD). A switch element is electrically connected with its associated diode such that the associated diode is connected between collector and emitter of the switch element. In this way, current can be conducted via the diode in one direction.

In an embodiment, the first switch is an HS switch, connected to a DC+ terminal. The first switch element and the first diode are in this case called HS switch element and HS diode, respectively. The second switch is an LS switch, connected to a DC- terminal. The second switch element and the second diode are in this case called LS switch element and LS diode, respectively.

In an alternative embodiment, the first switch is an LS switch and the second switch is an HS switch.

The arrangement of the switch elements and diodes next to each other in the specified order is symmetric in the sense that the order of sides to which the components are attributed is the same in both directions. This enables reducing stray inductance. Furthermore, also the lengths of commutation paths between a switch element, the diode of the other side and a DC terminal can be confined, which reduces the inductance of loop currents.

In an embodiment, the first switch element is located next to the second diode and the first diode is located next to the second switch element. Accordingly, the switches and diodes of different sides are located next to each other, leading to short commutation paths. In some embodiments, the second switch element is arranged closer to the first diode than the associated second diode.

The power module may comprise at least three DC terminals located on the same side of the power module, wherein the DC terminals have alternating polarity. As an example, the layout of the terminals may be DC+/DC-/DC+. Alternatively, the layout of the terminals may be DC-/DC+/DC-. It is also possible that the power module has further DC terminals of alternating polarity on the same side. The power module may comprise an AC terminal located on a side opposite to the DC terminals.

The power module may comprise metallizations. The metallizations may be in the form of DC+, DC- and AC metallizations connected to the respective terminals. The switch elements and diodes may be located on the DC+ and AC metallizations. The metallizations may be arranged in the form of strips parallel to each other.

In embodiments, each of the first and second switches comprises several switch elements and associated diodes connected in parallel to other switch elements and associated diodes of the same switch. Each of the switches may comprise an odd number of switch elements and associated diodes. As an example, each of the switches may comprise three switch elements and associated diodes.

The power module may have a highly symmetric layout. As an example, the switch elements of the same switch may be located in a row. The switch elements may be located at regular distances. Also the associated diodes of the same switch may be located in a row. Each of the switch elements of the same switch may be located on the same metallization. Also each of the associated diodes may be located on the same metallization.

In embodiments, the power module comprises additional first switch elements, associated additional first diodes, additional second switch elements and associated additional second diodes, located in the same column as the first and second switch elements and associated diodes. The additional switch elements and diodes may be arranged in the same order as the first and second switch elements and diodes. The additional switch elements and diodes can also be arranged in an opposite order than the first and second switch elements and diodes. The additional first and second switch elements and associated diodes may be electrically connected in parallel to the first and second switch elements and associated diodes.

Accordingly, the pattern of switch elements and diodes is repeated along the column. In addition to that, the switches may comprise further switch elements and diodes arranged in the same row of first and second switch elements and diodes.

The present disclosure comprises several embodiments. Every feature described with respect to one of the embodiments is also disclosed herein with respect to the other embodiment, even if the respective feature is not explicitly mentioned in the context of the specific embodiment.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
- Figure 1: is a schematic circuit diagram of a power module in form of a half bridge,
- Figure 2: is a schematic view of a power module according to an embodiment,
- Figure 3: is a top view of a power module according to the layout of Figure 2,
- Figure 4: is a detailed view of a gate metallization layout of the embodiment of Figure 3,
- Figure 5: is a detailed view of an alternative gate metallization layout for the embodiment of Figure 3,
- Figures 6, 7, 8, 9: are schematic views of power modules according to further embodiments.

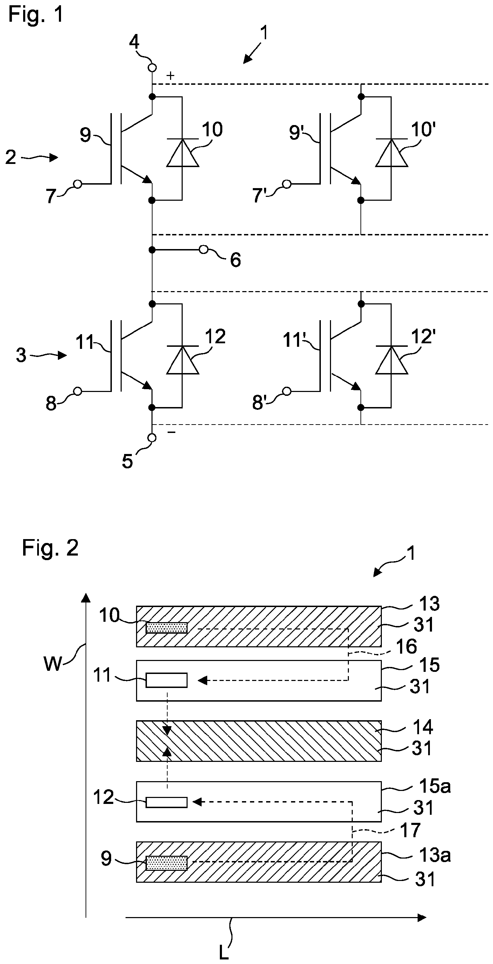

Figure 1 shows a schematic circuit diagram of a power module 1 in form of a half bridge. The power module 1 may be used in a motor drive or power converter in an electric vehicle, for example.

The power module 1 comprises a first switch 2 and a second switch 3 connected in series between two DC+/- terminals 4, 5 with an AC terminal 6 connected between the switches 2, 3. When providing a voltage between the DC+/- terminals 4, 5 and alternatingly switching on and off the switches 2, 3 at gate terminals 7, 8, an AC voltage is generated at the AC terminal 6.

The first switch 2 comprises a first switch element 9 and an associated first diode 10. The first diode 10 is connected between an emitter and a collector of the first switch element 9. The second switch 3 comprises a second switch element 11 and an associated second diode 12, which is connected between an emitter and a collector of the second switch element 11. The switch elements 9, 11 may be insulated-gate bipolar transistors (IGBT). The diodes 10, 12 may be free-wheeling diodes (FWD). The first switch 2 is in this case directly connected to the DC+ terminal and is also called "high side" (HS) switch. The first diode 10 and the first switch element 9 are called HS diode 10 and HS switch element 9, respectively. The second switch 3 is in this case directly connected to the DC- terminal and is also called "low side" (LS) switch. The second diode 11 and the second switch element 12 are called LS diode and LS switch element, respectively.

It is also possible that the first switch 2 comprises one or more further first switch elements 9' and associated further first diodes 10' connected in parallel to the first switch element 9 and associated first diode 10 and the second switch 3 comprises one or more further second switch elements 11' and one or more associated further second diodes 12' connected in parallel to the second switch element 11 and the associated second diode 12.

The one or more further first switch elements 9' may have the same features as the first switch element 9. The same applies for the further second switch elements 11', further first diodes 10' and further second diodes 12' in relation to the second switch element 11, first diode 10 and second diode 12, respectively. The first switch element 9 and further first switch elements 9' are also denoted as first switch elements 9, 9', the second switch element 11 and the further second switch elements 11' are also denoted as second switch elements 11, 11' in the following. The first diode 10 and further first diodes 10' are also denoted as first diodes 10, 10', and the second diode 12 and the further second diodes 12 are also denoted as second diodes 12, 12' in the following.

As an example, an odd number of first switch elements 9, 9' and associated diodes 10, 10' may be connected in parallel and an odd number of second switch elements 11, 11' and associated second diodes 12, 12' may be connected in parallel.

During switching, commutation loop currents flow between the first switch 2 and the second switch 3 and the associated commutation loop inductance impacts the switching speed.

Figure 2 shows an embodiment of a layout scheme of a power module 1 comprising a half-bridge in accordance with the circuit diagram of Figure 1. Only first and second switch elements 9, 11 and associated diodes 10, 12 are depicted. The Further first and second switch elements can be present in a corresponding arrangement shifted along a length direction L.

The switch elements 9, 11 and associated diodes 10, 12 are located on metallizations 31 on a substrate. The metallizations 31 can also be denoted as "traces". In particular, the first switch element 9 and the first diode 10 are located on DC+ metallizations 13, 13a and the second switch element 11 and the second diode 12 are located on AC metallizations 15, 15a. In the shown embodiment, the first switch element 9 and the first diode 10 are the HS switch element and HS diode, respectively. The second switch element 11 and the second diode 12 are the LS switch element and LS diode, respectively.

The switch elements 9, 11 and associated diodes 10, 12 are arranged next to each other in the order: first switch element 9 - second diode 12 - first diode 10 - second switch element 12 (in Figure 2 from bottom to top). The order of the sides of the components (HS-LS-LS-HS) is the same when going from bottom to top or from top to bottom. The elements are arranged in a column along a width direction W of the power module 1. In this arrangement, the first switch element 9 is not located adjacent to the associated first diode 10. Instead, the first switch element 9 and the second diode 12 are located as a pair close to each other and the second switch element 11 and the first diode 10 are located as a pair close to each other. Thus, the switch elements 9, 11 and diodes 10, 11 of different sides are spatially clustered as pairs. This has the effect that a current commutation path 16 from the first diode 10 via the second switch element 11 to a DC- metallization 14 is spatially well defined and confined. Also a current commutation path 17 from the first switch element 9 via the second diode 12 to the DC- metallization 14 is spatially well defined and confined. Thereby, the inductance of the commutation loops is minimized.

The two DC+ metallizations 13, 13a are on the same electric potential but may be connected to separate terminals. The two AC metallizations 15, 15a are on the same AC potential. The AC metallizations 15, 15a may be connected to a single terminal.

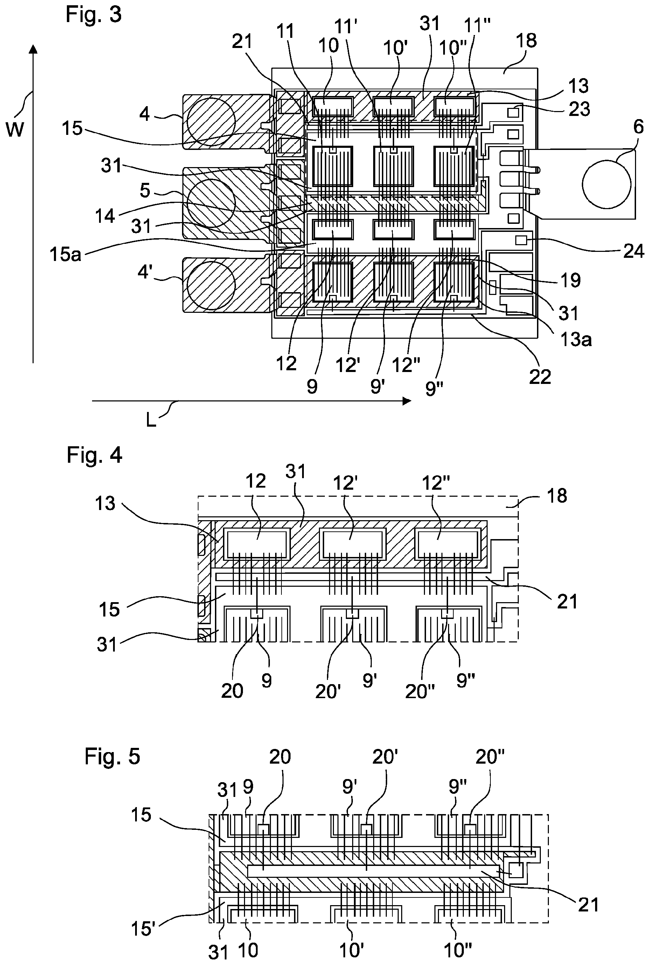

Figure 3 shows a top view of an embodiment of a power module 1 with the layout scheme of Figure 2 arranged on a substrate 18.

In the shown embodiment, three first diodes 10, 10', 10" are located next to each other on the same DC+ metallization 13, associated to three first switch elements 9, 9', 9'' located next to each other on the further DC+ metallization 13a. Three second diodes 12, 12', 12'' are located next to each other on the same AC metallization 15, associated with three second switch elements 11, 11', 11'' located next to each other on the same, further AC metallization 15a. Accordingly, the embodiment has three switch elements and associated diodes per side. The switch elements and associated diodes are located at regular distances only shifted relative to each other along the length direction L. The diodes and switch elements of each side are located next to each other along a length direction L on the same metallization, corresponding to a parallel connection of several first switches and a parallel connection of several second switches in the circuit diagram of Figure 1. The shown arrangement of diodes and switch elements is very regular and, thereby, a balanced distribution of loads and losses for the diodes and switch elements can be achieved.

While the layout scheme shows three diodes and switch elements per side located on the same metallization, more or less than three diodes per side may be present. In embodiments, only a single diode and a single switch element per side may be present.

The AC metallizations 15, 15a are connected to a single AC terminal 6. The DC+ metallizations are connected to two separate DC+ terminals 4, 4' instead of the single terminal 4 shown in Figure 1. The DC+ terminals 4, 4' enclose a DC-terminal 5 and are located at a side opposite than the AC terminal 6.

Each of the switch elements 9, 9', 9", 11, 11', 11'' and each of the diodes 11, 11', 11'' and 12, 12', 12'' is connected to an adjacent DC+, DC- or AC metallization 13, 13a, 14, 15, 15a, by wire bonds 19. In this embodiment, also the wire bonds 19 are homogeneously directed along the width direction W. Overall, a very lean layout of metallizations and connection structures is achieved. Thereby, the chip placement area can be maximized and heat spreading can be increased.

Figure 4 shows in a detailed view of a gate metallization layout of the embodiment of Figure 3. The position of the detailed view is indicated in Figure 3 by dashed lines.

Gates 20, 20', 20'' of the second switch elements 11, 11', 11'' are connected to a gate metallization 21 arranged between the first DC+ metallization 13 and the first AC metallization 15. As can be seen from Figure 3, the gates of the first switch elements 9, 9', 9'' are connected to a second gate metallization 22 located between the second DC+ metallization 13a and an edge of the substrate 18. Depending on the overall layout, the second gate metallization 22 may be alternatively located between the second DC+ metallization 13a and the second AC metallization 15a, corresponding to the position of the first gate metallization 21. As can be seen, a very lean layout of gate metallizations is achieved.

Figure 5 shows in a detailed view an example of an alternative gate metallization layout which can be embodied in the power module 1 of Figure 3 instead of the gate metallization layout shown in Figure 4. In Figure 5, the first gate metallization 21 is located on the DC-metallization. As in Figure 4, the first gate metallization 21 is in the form of an elongate strip, arranged in parallel to the DC+, DC- and AC metallizations.

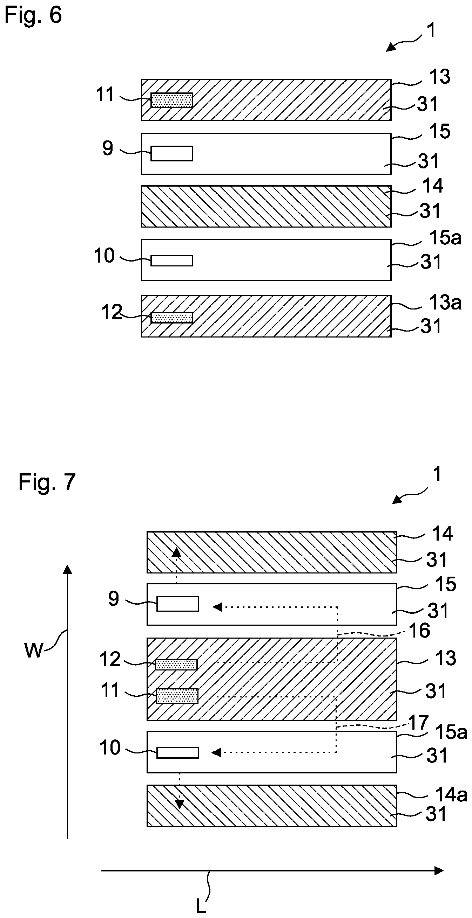

Figures 6, 7, 8 and 9 show further layouts of embodiments of power modules 1.

Figure 6 shows a layout of a power module 1, in which, compared to Figure 3, the locations of the second switch element 11 and the second diode 12 have been swapped. Also in this case, the arrangement of the diodes and switches along the length direction L is homogenous. Thereby, a balanced distribution of loads and losses for the diodes and switches within the sides is achieved.

In contrast to the embodiment of Figure 2, the switch elements 9, 11 of different sides are arranged close to each other and the diodes 10, 12 of different sides are arranged close to each other. The switch elements 9, 11 are arranged at a distance from the associated diodes 10, 12. The pairs of switch elements 9, 11 are separated by an AC metallization 15 from the pairs of the diodes 10, 12.

The metallizations 13, 13a, 14, 15, 15a are elongated strips arranged parallel to each other in a single row. Also here, in case of several switches per side, the further sets of switch elements and diodes of the switches are positioned on along the respective metallization at regular distances in a row, i.e., along the length direction L.

The switch elements 9, 11 can be connected to gate metallizations arranged adjacent to the AC metallization 15 and DC+ metallization 13, respectively. As an example, a first gate metallization for connection to the HS switch element 11 may be located at the side of the DC+ metallization 13a facing away from the AC metallization 15a. A second gate metallization for connection to the LS switch element 9 may be located adjacent to the AC metallization 15, e.g., between the DC+ metallization 13 and the AC metallization 15. The second gate metallization may be alternatively located on the DC- metallization 14.

The relative arrangment of the further switch elements 9', 9", 11', 11" and further diodes 10', 10", 12', 12" is the same but only shifted along the length direction L.

Figure 7 shows a further layout of a power module 1. In this embodiment, the DC-metallizations and associated terminals are not arranged in a '+/-/+'-scheme (from top to bottom in the figure) but are arranged in a '-/+/-'-scheme.

In this embodiment, the first switch element 9 and the first diode 10 are parts of the HS switch and the second switch element 11 and the second diode 12 are part of the LS switch. Also here, the order of the sides (HS-LS-LS-HS) is the same when going from bottom to top or from top to bottom. The second switch element 11 and the second diode 12 are located close to each other on the same DC+ metallization 13 at different positions along the width direction W. The first switch element 11 and the associated first diode 12 are arranged close to each other. However, the first switch element 9 and the associated diode 10 are separated from each other by the DC+ metallization 13 and the second switch element 11 and the second diode 12. Also in this embodiment, the commutation path 16 from the second diode 12 via the first switch element 9 to the DC- metallization 14 and also the commutation path 17 from the second switch element 11 via the first diode 10 to the DC- metallization 14a is short and the inductance is low.

As in the previous embodiments, the first set of switch elements 9, 11 and associated diodes 10, 12 of the switches are arranged at the same positions along the length L of the power module 1. The second set of switch element 9', 11' and associated diodes 10', 12' is arranged identically but only shifted along the length direction L. Also the third set of switch elements 9'', 11'' and associated diodes 10", 12'' is arranged identically but only shifted along the length direction L.

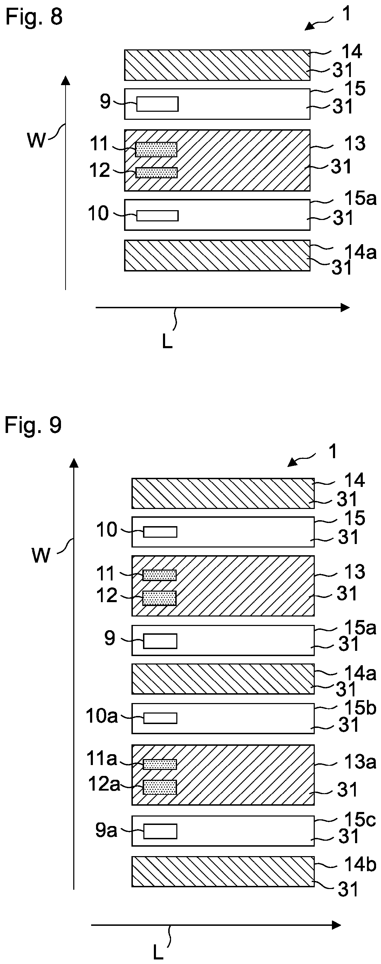

Figure 8 shows a further layout of a power module 1. In comparison to the layout of Figure 7, the positions of the second switch elements 11, 11', 11'' and the positions of the associated diodes 12, 12', 12'' are swapped. Also in this case, a balanced load and loss distribution can be obtained.

Figure 9 shows a further layout of a power module 1. In this embodiment, the DC-metallizations and associated terminals are arranged in a '-/+/-/+/-'-scheme along the width direction W.

The shown embodiment is obtained when the layout scheme shown in Figure 8 is doubled in the width direction W, with a shared DC- terminal 14a. Accordingly, the power module 1 comprises a first set of switches forming a half-bridge, the first set comprising first and second switch elements 9, 11 and associated diodes 10, 12 and a second set of switches comprising additional switch elements 9a, 11a and associated additional diodes 10a, 12a. Due to a separation of the respective metallizations within the power module 1, the parallel connection may be established when the module terminal is further connected, to an inverter, for example.

Further sets of identically arranged switches are located at positions shifted along the longitudinal direction L, exemplarily at regular distances from each other. Accordingly, the layout is symmetric in regard of the arrangement of the switch elements and diodes in a direction along the metallizations. Exemplarily, the switch elements and diodes of each side are merely shifted along the metallization direction but the layout does not change along the metallization.

Simulations of the layout shown in Figure 3 show that mutual coupling inductances for each switch element between the associated commutation loop and gate loop are negative and well-balanced and, thus, a proper dynamic current sharing can be accomplished. In addition to that, the switching behavior at a simulated turn-off of switch elements and turn-on on diodes for all three switch elements is well-aligned and, thus, a good balance is accomplished between switch elements of the switches. Also the switching behavior of the diodes is well-balanced.

### Reference Signs

- 1: power module
- 2: first switch
- 3: second switch
- 4, 4': DC+ terminal
- 5: DC- terminal
- 6: AC terminal
- 7: first gate terminal
- 8: second gate terminal
- 9: first switch element
- 9', 9", 9a: further first switch element
- 10: first diode
- 10', 10", 10a: further first diode
- 11: second switch element
- 11', 11", 11a: further second switch element
- 12: second diode
- 12', 12", 12a: further second diode
- 13, 13a: DC+ metallization
- 14, 14a, 14b: DC- metallization
- 15, 15a, 15b, 15c: AC metallization
- 16: commutation path
- 17: commutation path
- 18: substrate
- 19: wire bond
- 20, 20', 20": gate
- 21: first gate metallization
- 22: second gate metallization
- 23: first gate terminal
- 24: second gate terminal
- 25: simulation result for embodiment
- 26: simulation result for reference
- 27: additional first switch element
- 28: additional first diode
- 29: additional second switch element
- 30: additional second diode
- 31: metallization

- U: voltage
- I: current
- W: width direction
- L: length direction

## Claims

1. A power module (1) comprising
- a first switch (2) comprising a first switch element (9) and an associated first diode (10),
- a second switch (3) comprising a second switch element (11) and an associated second diode (12),
- the first switch (2) and the second switch (3) being electrically connected to form a half-bridge,
- wherein the first switch element (9), the second switch element (11), the first diode (10) and the second diode (12) are located next to each other, wherein the second switch element (11) and the second diode (12) are located between the first switch element (9) and the first diode (10).

2. The power module (1) of claim 1,
wherein the first switch (2) comprises one or more further first switch elements (9', 9") and associated further first diodes (10', 10") and the second switch (3) comprises one or more further second switch elements (11', 11") and associated further second diodes (12', 12"), wherein the first switch element (9) and the further first switch elements (9', 9") are located next to each other in a row, the second switch element (11) and the further second switch elements (11', 11") are located next to each other in a row, the first diode (10) and the further first diodes (10', 10") are located next to each other in a row and the second diode (12) and the further second diodes (12', 12") are located next to each other in a row.

3. The power module (1) of claim 2,
wherein the power module (1) comprises metallizations (31), wherein the first switch element (9) and the one or more further first switch elements (9', 9'') are located on the same one of the metallizations (31) and wherein the second switch element (11) and the one or more further second switch elements (11', 11") are located on the same one of the metallizations (31).

4. The power module (1) of claim 3,
wherein the metallizations (31) are arranged in the form of strips parallel to each other.

5. The power module (1) of any of the preceding claims,
wherein the first switch element (9) is located next to the second diode (12) and the first diode (10) is located next to the second switch element (11).

6. The power module (1) of any of claims 1 to 5,
wherein the first switch element (9) is located next to the second switch element (11) and the first diode (10) is located next to the second diode (12).

7. The power module (1) of any of the preceding claims, comprising at least three DC terminals in the form of at least one DC- terminal (5) and at least one DC+ terminal (4, 4'), the three DC terminals being located on one side of the power module (1) and having alternating polarity and comprising at least one AC terminal (6) located on an opposite side of the power module (1).

8. The power module (1) of any of the preceding claims, comprising metallizations (31) on which the first and second switch elements (9, 11) and associated first and second diodes (10, 12) are located, wherein the second diode (12) and the second switch element (11) are separated by one of the metallizations (31).

9. The power module of any the preceding claims,
comprising metallizations (31) on which the first switch element (9), the second switch element (11), the first diode (10) and the second diode (12) are located, wherein the second switch element (11) and the second diode (12) are located on the same one of the metallizations (31).

10. The power module (1) of any of the preceding claims,
wherein the second diode (12) is located closer to the first switch element (9) than to the second switch element (11).

11. The power module (1) of any of the preceding claims,
wherein the first switch (9) is a low side switch connected to a DC- terminal (5) and the second switch (11) is a high side switch connected to a DC+ terminal (4, 4').

12. The power module (1) of any claims 1 to 10,
wherein the first switch (9) is a high side switch connected to a DC+ terminal (4, 4') and the second switch (11) is a low side switch connected to a DC- terminal (5).

13. The power module (1) of any of the preceding claims, comprising at least one additional first switch element (9a), associated additional first diode (10a), additional second switch element (11a) and associated additional second diode (12a) located in the same column as the first switch element (9), the second switch element (9), the first diode (19) and the second diode (12).

14. The power module (1) of any of the preceding claims, comprising a gate metallization (21, 22) connected to a gate (20) of the second switch element (11), wherein the gate metallization (21, 22) has the form of a strip located between the second switch element (11) and one of the first diode (10) and the second diode (12) located next to the second switch element (11).

15. The power module (1) of any of the preceding claims,
wherein the first switch (2) comprises one or more further first switch elements (9', 9") and the second switch (3) comprises one or more further second switch elements (11', 11''), wherein each of the first switch (2) and the second switch (3) has an odd number of switch elements (9, 9', 9", 11, 11', 11").
